# DEMANDE DE BREVET EUROPEEN

(11) **EP 2 323 076 A1**
(43) Date de publication de la demande: **18.05.2011**
(21) Numéro de dépôt: 09306089.5
(22) Date de dépôt: 12.11.2009
(51) Int. Cl.: G06K 19/077, H05K 3/00

(54) **Procédé d'usinage d'un corps de carte et station d'usinage associée.**

(71) Demandeur: Gemalto SA, 92190 Meudon (FR)
(72) Inventeur: Durano, Frederic, 92197, MEUDON (FR); Froger, Alexis, 92197, MEUDON (FR); Poitrasson, Eric, 92197, MEUDON (FR); Renouard, Jérémy, 92197, MEUDON (FR); Spinelli, Laurent, 92197, MEUDON (FR)
(74) Mandataire: Cour, Pierre

(57) **Abrégé**

L'invention concerne un procédé d'usinage d'un corps de carte (1), comportant les étapes suivantes :
- prédécoupage des contours externes (5) d'au moins une cavité à usiner (6; 7) sur le corps de carte (1) par un outil tranchant (2) comportant au moins une lame (4),
- enlèvement de matière par usinage dudit corps de carte (1) à l'intérieure des contours prédécoupés (5) de manière à former au moins une cavité sur le corps de carte (1).

L'invention concerne également une station d'usinage d'un corps de carte (1) pour la mise en oeuvre du procédé tel que décrit précédemment, comportant un module d'usinage (3) et un outil tranchant (2) associé, comportant au moins une lame (4).

## Description

La présente invention se rapporte au domaine technique des procédés d'usinage, et plus particulièrement aux procédés d'usinage de corps de cartes.

De façon générale, les procédés d'usinage dont le but est de former des cavités dans des corps de cartes de matières comme les matières plastiques, par exemple les matières à base de polychlorure de vinyle (PVC) ou encore d'acrylonitril butadiène styrène (ABS), sont bien connus. Ces cavités pouvant ultérieurement recevoir des objets tels que des hologrammes, puces électroniques ou bien encore des bandes magnétiques. Cependant, ces mêmes procédés d'usinage sont difficilement applicables à d'autres matières comme des matières fibreuses ou biodégradables car ils entrainent, du fait même de leur structure, des bavures et des imperfections importantes. Ces bavures et imperfections se retrouvent ensuite au niveau du produit fini, après l'enrobage du corps de carte, donnant un produit fini dont la surface est parsemée d'imperfections et de bosses.

L'invention a donc pour objectif de pallier à ces inconvénients et de proposer un procédé d'usinage de corps de carte.

Ainsi, la présente invention concerne un procédé d'usinage d'un corps de carte, comportant les étapes suivantes :
- prédécoupage des contours externes d'au moins une cavité à usiner sur le corps de carte par un outil tranchant comportant au moins une lame,
- enlèvement de matière par usinage dudit corps de carte à l'intérieur des contours prédécoupés de manière à former au moins une cavité sur le corps de carte.

Par ce prédécoupage, on obtient des contours externes sans bavures et imperfections issues d'un usinage classique lors de la formation de cavités.

Selon un aspect de l'invention, le corps de carte est réalisé en matière biodégradable. Par biodégradable, on entend une matière fibreuse qui sous l'action d'organismes vivants extérieure à sa substance peut se décomposer en éléments divers dépourvus d'effets dommageable sur le milieu naturel.

Selon un aspect de l'invention, le corps de carte est réalisé en matière fibreuse. Par matière fibreuse, on entend une matière disposant d'une structure orientée dans un sens précis comme par exemple un matériau à base de cellulose.

Selon un aspect de l'invention, l'étape de prédécoupage est réalisée par un mouvement descendant/ascendant de l'outil tranchant sur le corps de carte.

Selon un autre mode de réalisation, l'outil tranchant comporte un ensemble de lames dont la disposition correspond aux contours externes de la dite au moins une cavité à usiner.

L'invention concerne également une station d'usinage d'un corps de carte réalisé pour la mise en oeuvre du procédé d'usinage comportant au moins une première étape de prédécoupage du corps de carte, suivi d'une étape de enlèvement de matière, ladite station d'usinage comportant un module d'usinage et un outil tranchant associé, ledit outil tranchant comporte au moins une lame.

Selon un aspect de l'invention, l'outil tranchant réalise un mouvement ascendant/descendant sur le corps de carte.

Selon un autre aspect de l'invention, l'outil tranchant comporte un ensemble de lames dont la disposition correspond aux contours externes de cavités à usiner.

D'autres caractéristiques et avantages de l'invention apparaîtront plus clairement à la lecture de la description suivante, donnée à titre d'exemple illustratif et non limitatif, et du dessin annexé :
- La figure 1 représentant un schéma simplifié d'un corps de carte en vue de dessus.
- La figure 2 représentant un schéma simplifié d'un mode de réalisation de l'invention.

L'objet de l'invention concerne un procédé d'usinage d'un corps de carte, comportant au moins une première étape de prédécoupage du corps de carte, suivi d'une étape d'enlèvement de matière sur ledit corps de carte.

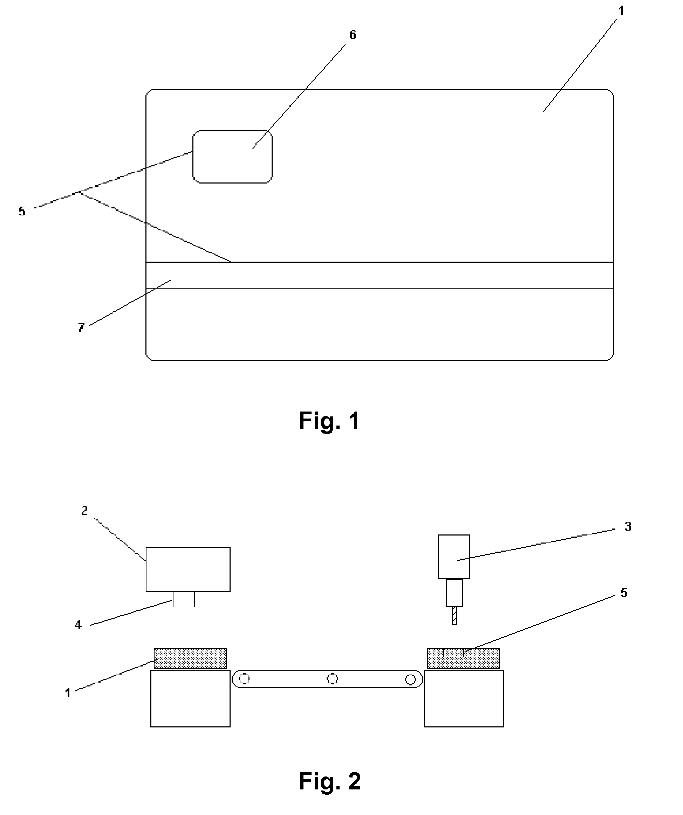

La figure 1 montre un corps de carte 1 dont les contours des cavités à usiner sont prédécoupés. La cavité 6 peut recevoir par exemple une puce électronique et la cavité 7 peut recevoir par exemple une bande magnétique.

L'étape de prédécoupage est réalisée par un outil tranchant comportant au moins une lame. Ledit outil tranchant est destiné à découper la matière composant le corps de carte 1 et ainsi définir précisément les contours de la cavité usiner. Ces prédécoupes sont faites sur le corps de carte 1 de façon à ce qu'elles forment les contours externes des cavités à usiner 6 et 7. L'outil tranchant procède au prédécoupage du corps de carte, par exemple par mouvement descendant/ascendant. L'outil tranchant peut comporter un ensemble de lames dont la disposition correspond aux contours externes des cavités à usiner.

L'étape d'enlèvement de matière sur le corps de carte est réalisée par un module d'usinage, par exemple de type fraise, et elle consiste à réduire l'épaisseur du corps carte 1 à l'intérieure des contours prédécoupés 5 par enlèvement de matière. L'usinage du corps de carte ne consiste donc pas à former les cavités, mais à retirer de la matière entre et aux abords des prédécoupes 5, empêchant ainsi la formation de bavures, d'imperfections et de déformations liées à un usinage classique pour la formation de cavités.

Un avantage supplémentaire de l'invention est que le contrôle de la profondeur des prédécoupes par l'outil tranchant permet l'utilisation des outils standards d'usinage, réduisant ainsi les coûts de production.

L'objet de l'invention concerne également une station d'usinage d'un corps de carte, comportant un module d'usinage et un outil tranchant associé, composé d'au moins une lame.

La figure 2 illustre un mode de réalisation d'une station d'usinage selon l'invention. La station d'usinage comporte ici d'un outil tranchant 2 comportant au moins une lame 4 et d'un module d'usinage 3, par exemple de type fraise. Dans mode de réalisation présenté, l'outil tranchant 2 réalise les prédécoupes 5 par un mouvement descendant/ascendant sur le corps de carte 1. La disposition des lames 4 correspond aux contours externes 5 de la cavité à usiner.

## Revendications

1. Procédé d'usinage d'un corps de carte (1), **caractérisé en ce que** ledit procédé d'usinage comporte les étapes suivantes :
- prédécoupage des contours externes (5) d'au moins une cavité à usiner (6 ; 7) sur le corps de carte (1) par un outil tranchant (2) comportant au moins une lame (4),
- enlèvement de matière par usinage dudit corps de carte (1) à l'intérieure des contours prédécoupés (5) de manière à former au moins une cavité sur le corps de carte (1).

2. Procédé selon la revendication 1, **caractérisé en ce que** le corps de carte (1) est réalisé en matière biodégradable.

3. Procédé selon l'une des revendications précédentes, **caractérisé en ce que** le corps de carte (1) est réalisé en matière fibreuse.

4. Procédé d'usinage selon l'une des revendications précédentes, **caractérisé en ce que** l'étape de prédécoupage est réalisée par un mouvement descendant/ascendant de l'outil tranchant (2) sur le corps de carte (1).

5. Procédé d'usinage selon l'une des revendications précédentes, **caractérisé en ce que** l'outil tranchant (2) comporte un ensemble de lames (4) dont la disposition correspond aux contours externes de cavités à usiner.

6. Station d'usinage d'un corps de carte (1) pour la mise en oeuvre du procédé d'usinage selon la revendication 1, comportant un module d'usinage (3) et un outil tranchant (2) associé, comportant au moins une lame (4).

7. Station d'usinage selon la revendication 6, **caractérisé en ce que** l'outil tranchant (2) réalise un mouvement ascendant/descendant sur le corps de carte (1).

8. Station d'usinage selon les revendications 6 et 7, **caractérisé en ce que** l'outil tranchant (2) comporte un ensemble de lames (4) dont la disposition correspond aux contours externes de cavités à usiner.
